# EUROPEAN PATENT SPECIFICATION

(11) **EP 0 268 419 B1**
(45) Date of publication and mention of the grant of the patent: **09.04.1997**
(21) Application number: 87309961.8
(22) Date of filing: 11.11.1987
(51) Int. Cl.: G06F 12/06

(54) **Memory cartridge and data processing apparatus**
Speicherkassette und Datenverarbeitungsvorrichtung
Cassette de mémoire et dispositif de traitement de données

(30) Priority: 19.11.1986 JP 277543/86
(43) Date of publication of application: 25.05.1988
(73) Proprietor: NINTENDO CO. LIMITED, Higashiyama-ku Kyoto (JP)
(72) Inventor: Nakanishi, Yoshiaki, Higashiyama-ku Kyoto (JP); Nagagawa, Katsuya, Higashiyama-ku Kyoto (JP)
(74) Representative: Arthur, Bryan Edward

(56) References cited:
- US-A- 4 386 773
- US-A- 4 485 457
- US-A- 4 601 018

## Description

### BACKGROUND OF THE INVENTION

### Field of the Invention

The present invention relates to a memory cartridge. More specifically, the present invention relates to a memory cartridge which can be attached to and detached from a data processing unit such as a home video gaming machine which is used by connecting to a normal television receiver, and is loaded to that data processing unit when used.

### Description of the Prior Art

For the data processing unit in which an image is displayed on a television receiver, a video gaming machine called "Family Computer" (trade mark) or"Nintendo Entertainment System"(trade mark) which is manufactured and sold by the applicant of the present invention and a personal computer called "MSX" (trade mark) are exemplified. These data processing units are enabled by loading an external memory cartridge into which a program of game software, education software or the like is written in advance. A read-only memory (ROM) for storing program data and character data for display are contained in the memory cartridge.

For the memory cartridge as described above, recently, a memory having a larger capacity, for example, 1 M bits or 4 M bits is sometimes incorporated therein. In the case where such a large-capacity memory is employed, since address space accessible from a central processing unit in the data processing unit is limited, the so-called "bank change-over" approach has to be employed.

Conventionally, United States Patent No. 4,432,067 has been known as a method for expanding a memory capacity while the number of address lines being connecting to the data processing unit, that is, as address space is maintained at a predetermined number. United States Patent No. 4,432,067 discloses a memory cartridge in which an address decoder, a latch circuit, a supplemental memory chip and a signal line for selecting memory chip.

In United States Patent No. 4, 432,067, the address decoder detects a timing when an address data becomes a specific address representing that the memory chip should be changed-over, and then the memory chip is changed-over by the latch circuit and the signal line. This means that the change-over of the memory chip is controlled by a dedicated hardware circuit and only performed memory chip basis. Therefore, it is impossible to change-over of the bank of an arbitrary memory size. Furthermore, since only the change-over fixedly determined by the hardware circuit can be executed, there are many restrictions in designing a program of a game or the like.

United States patent No. 4,601,018 discloses a memory circuit including a plurality of memory banks, a bank selection circuit for selection of one of the plurality of banks, and an access circuit. Each bank is capable of storing the same amount of information.

United States patent No. 4,613,953 discloses an addressing and control system for a single mass memory which is partitioned into selectable pages of individualy specified size. A register is used to latch page size and selection information for use in addressing pages of the mass memory. The page size and selection information is placed on a data bus by a microprocessor while the mass memory is disabled.

### SUMMARY OF THE INVENTION

Therefore, the principal object of the present invention is to provide a memory cartridge enabling bank change-over of a memory of an arbitrary memory size.

Another object of the present invention is to provide a memory cartridge capable of changing-over banks by a program of a data processing unit and thus the degree of freedom of program design will increase.

Still another object of the present invention is to provide a memory cartridge capable of increasing function as an external memory.

According to a first aspect, the present invention is a data processing apparatus as set out in claim 1.

According to a second aspect, the present invention is a memory cartridge as set out in claim 12.

In accordance with the present invention, the memory controlling means gives the address for bank change-over of the memory based on the data from the microprocessor of the data processing unit, and therefore an arbitrary bank of the memory can be selectively enabled by changing the data from the microprocessor. Accordingly, by making the microprocessor properly change the data thereof attending on the progress of the program step, resultingly the bank change-over of the memory can be executed according to the program.

For that reason, the memory cartridge in accordance with the present invention can outstandingly improve the degree of freedom in designing or using the program in comparison with the conventional memory cartridge wherein the bank change-over is made only by a hardware circuit.

These objects and other objects, features, aspects and advantages of the present invention will become more apparent from the following detailed description of the embodiments of the present invention when taken in conjunction with accompanying drawings.

### BRIEF DESCRIPTION OF THE DRAWINGS

Fig. 1 is an exploded perspective view showing one embodiment in accordance with the present invention.

Fig. 2 is a block diagram showing one example of a data processing unit to which Fig. 1 embodiment is applicable.

Fig. 3 is a block diagram showing a configuration of Fig. 1 embodiment.

Fig. 4 is a plan view of an MMC.

Fig. 5 is a block diagram of the MMC as shown in Fig. 4.

Fig. 6 is a circuit diagram of the MMC in accordance with the block diagram as shown in Fig. 5.

Figs. 7A and 7B are illustrative views for showing an address space of a CPU.

Fig. 8 is an illustrative view for showing an address space of a PPU.

Fig. 9 is an illustrative view for showing a memory map of a V-RAM.

### DESCRIPTION OF THE PREFERRED EMBODIMENTS

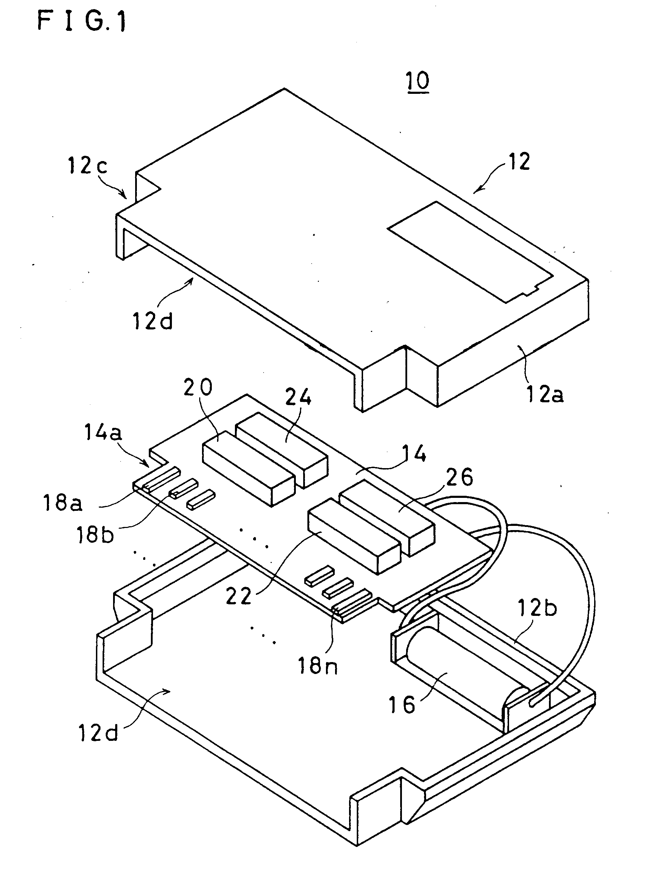

In reference to Fig. 1, a memory cartridge 10 of this embodiment includes a case 12 formed by an upper case 12a and a lower case 12b. The case 12 is formed nearly in a rectangle, and a protrusion 12c is formed at one side thereof. An opening 12d is formed by the protrusion 12c and the other sides of the case 12 are blocked by side walls.

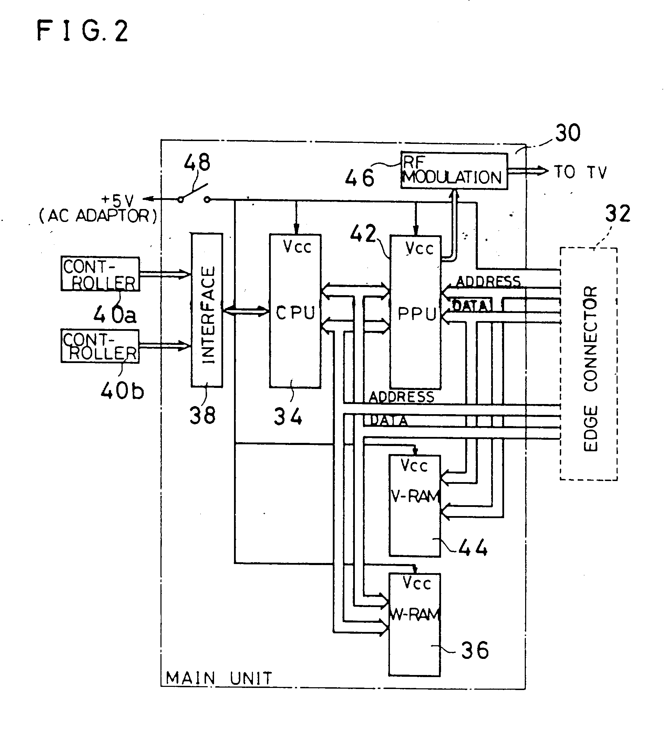

A printed circuit board 14 and a power supply 16 are housed in the case 12. A protrusion 14a is formed at the portion of the printed circuit board 14 corresponding to the protrusion 12c of the above-described case 12. The protrusion 14a of the printed circuit board 14 is exposed through the opening 12d of the case 12. Then, on the protrusion 14a, conductive patterns or connecting electrodes 18a - 18n constituting connecting means to an edge connector 32 (Fig. 2) of a gaming machine main unit 30 as described later are formed so as to be distributed in a direction that the side of the protrusion 14a extends.

A program memory 20 composed of a non-volatile semiconductor memory, for example, ROM or EEPROM is mounted on one of main surfaces of the printed circuit board 14. The program memory 20 has a memory area of, for example, 4 M bits, wherein a program data required for execution of a predetermined operation of a central processing unit (CPU) 34 (Fig. 2) included in the gaming machine main unit 30 is stored in advance. Also, a character memory 22 consisting of a similar non-volatile semiconductor memory is installed on the printed circuit board 14. The character memory 22 has a memory area of, for example, 1 M bits, wherein data (character data) relating to characters displayed for gaming or the like is stored in advance. An expansion memory 24 is further installed on the printed circuit board 14, and the expansion memory 24 can be utilized in the case where the capacity of the program memory 20 is not sufficient, being constituted with a RAM having a capacity of, for example, 64 K bits.

A multi-memory controller (MMC) 26 constituting one of features of this embodiment is installed on the printed circuit board 14. The MMC 26 receives data from the CPU 34 and a PPU 42 of the gaming machine main unit 30, being utilized to change-over banks of the program memory 20 and/or the character memory 22.

The aforementioned power supply 16 installed in the case 12 is utilized for back-up of the above-described expansion memory 24. For such a power supply 16, for example, the primary battery such as lithium battery or alkaline battery, the secondary battery which can be charged such as nickel-cadmium battery, or an electrostatic capacity type such as an electric double-layer capacitor can be utilized.

In addition, the above-described character memory 22 may be constituted with a RAM likewise the expansion memory 24, and in that case, a power supply for back-up will have to be provided likewise the expansion memory 24.

Meanwhile, the present invention is applicable to a memory cartridge in which a casing and a printed circuit board are united so as to be compact and thin, that is, a card-like memory such as so called an IC card.

The gaming machine main unit 30 as one example of the data processing unit for which the cartridge of the embodiment can be utilized is constituted as shown in Fig. 2. The electrodes 18a - 18n of the cartridge 10 are inserted into an edge connector 32 of the main unit 30, and thereby both are electrically connected to each other to constitute one system.

The gaming machine main unit 30 includes the eight-bit microprocessor (CPU) 34 for gaming, for example, the integrated circuit "2A03" manufactured by Nintendo, and gaming controllers 40a and 40b are connected to the CPU 34 through an I/O interface 38.

Furthermore, a working RAM (W-RAM) 36, the PPU 42 (picture processing unit), a video RAM (V-RAM) 44 and an RF modulator 46 are installed in the main unit 30. For the PPU 42, for example, the integrated circuit "2C02" manufactured by Nintendo is used, and the PPU 42 reads data of the character memory 22 and the V-RAM 44 under the control of the CPU 34, and converts the same into video signal, giving them to the RF modulator 46. The RF modulator 46 modulates the given video signal, outputting a television signal of, for example, NTSC standard for the television receiver as an image displaying means.

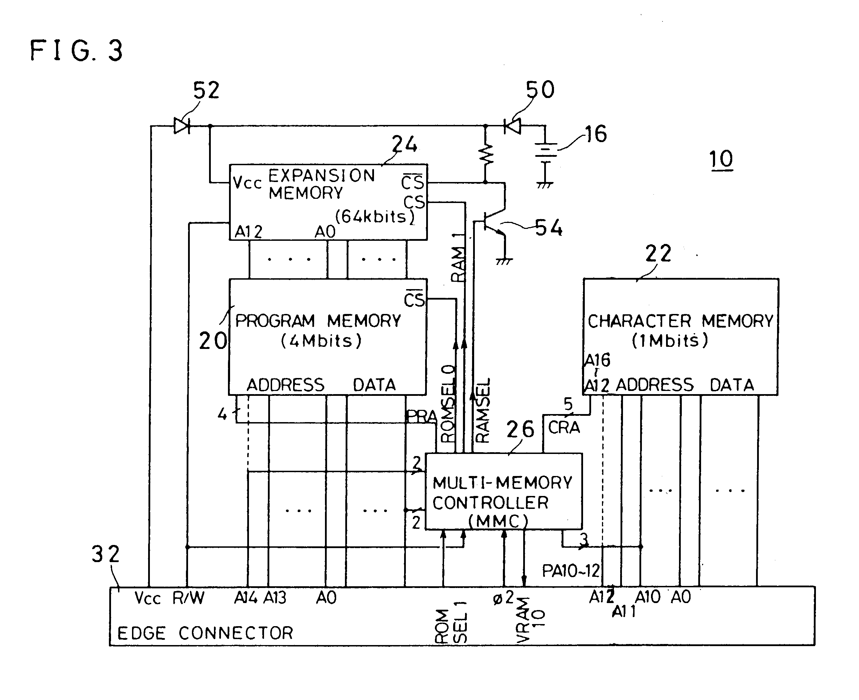

In reference to Fig. 3, detailed description is made on a configuration of the memory cartridge 10 as illustrated in Fig. 1, which is loaded in the edge connector 32 as shown in Fig. 2. As described above, the memory cartridge 10 is connected to the edge connector 32, being given various data or signals from the CPU 34 and the PPU 42 of the gaming machine main unit 30 through the edge connector 32.

The program memory 20 receives program addresses A0 -A13 from the CPU 34 (Fig. 2) and receives eight-bit data through the edge connector 32. A program address A14 from the CPU 34 is given to the MMC 26 along with the program address A13. On the other hand, the character memory 22 is given character addresses A0 - A11 from the PPU 42, and a character address A12 is given to the MMC 26 along with the character addresses A10 and A11. Then, eight-bit data is given to the character memory 22 from the PPU 42. The program addresses A0 - A12 and eight-bit data are given also to the expansion memory 24 likewise the program memory 20.

To the MMC 26, a system clock ^{φ}2 is given from the CPU 34 and also a signal ROMSEL1 specifying addresses 8000H - FFFFH of the program memory 20 is given. Also, a read/write signal R/W is given to the MMC 26 from the CPU 34. The read/write signal R/W is given also to the above-described expansion memory 24.

As described in detail later, a signal RAMSEL for enabling the expansion memory 24 is given to the expansion memory 24 from the MMC 26. In the case where 64 K-bit RAM of two chips are mounted as the expansion memory 24, a chip select signal RAM1 is further given to the expansion memory 24 from the MMC 26. Furthermore, the MMC 26 outputs a signal ROMSEL0 for enabling the program memory 20. Also, the MMC 26 acts as a controlling means for respectively bank changing-over of the program memory 20 and the character memory 22, and therefore from the MMC 26, four-bit program addresses PRA14 - PRA17 are given to the program memory 20 and five-bit character addresses CRA12 - CRA16 are given to the character memory 22.

The negative electrode of the power supply 16 included in the memory cartridge 10 is grounded, and the positive electrode thereof is connected to a power terminal Vcc of the edge connector 32 through a forward-direction diode 50 and a reverse-direction diode 52 connected to the diode 50. A power supply from the gaming machine main unit 30 is applied to this power terminal Vcc. The output of the diode 50 is connected to a chip select terminal CS of the expansion memory 24 through a resistor, also being connected to the collector of a transistor 54. The emitter of the transistor 54 is grounded, and the above-described signal RAMSEL from the MMC 26 is given to the base thereof. The output of the other diode 52 is connected to the power supply Vcc of the expansion memory 24.

Accordingly, in the case where the memory cartridge 10 is loaded in the gaming machine main unit 30 through the edge connector 32, the voltage Vcc is supplied to the expansion memory 24 through the diode 52. When the memory cartridge 10 is removed from the edge connector 32, or even if loaded, when a power switch 48 of the gaming machine main unit 30 is turned off, the voltage Vcc is given from the power supply 16 to the expansion memory 24 through the diode 50. Thus, the diode 50 acts as a switch for applying a voltage to the expansion memory 24, and also functions as a reverse flow blocking diode for preventing the current from the gaming machine main unit 30 from flowing into the power supply 16.

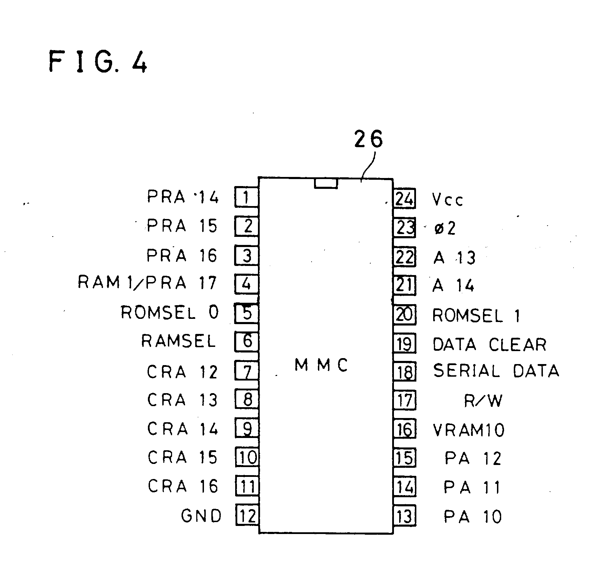

In reference to Fig. 4 through Fig. 6, further detailed description is made on the MMC 26 included in the memory cartridge 10. As shown in Fig. 4, the MMC 26 is constituted as one custom IC, and terminals No. 1 - No. 11 and No. 16 are used as output terminals, and terminals No. 13 - No. 15 and No. 17 - No. 23 are used as input terminals. A terminal No. 12 is connected to a ground potential GND and a terminal 24 is connected to the voltage Vcc.

To be detailed, the terminals No. 1 - No. 4 are utilized as output terminals of the four-bit program addresses PRA14 -PRA17, and among them, the terminal No. 4 is sometimes utilized as an output terminal of the chip select signal RAM1 of the expansion memory 24. In the case where a one-chip memory is used as the expansion memory 24 (Fig. 3), the signal RAM1 has not any meaning, and it acts as a one-bit chip select signal when two memory chips are mounted, selecting either of the chips by "1" or "0".

The terminal No. 5 is utilized as an output terminal of the signal ROMSEL0 to be given to the above-described program memory 20, and only when the program memory 20 is read, that is, only when the read/write signal R/W from the CPU 34 is high, it is outputted as a low-level signal.

The terminal No. 6 is an output terminal of the signal RAMSEL to be given to the above-described transistor 54, which specifies addresses 6000H - 7FFFH of the expansion memory 24.

The terminals No. 7 - No. 11 are utilized as output terminals of addresses for bank change-over of the character memory 22, that is, the character addresses CRA12 - CRA16.

The terminals No. 13 - No. 15 are utilized as input terminals of addresses PA10 - PA12 from the PPU 42.

The terminal No. 16 is an output terminal of a signal VRAM10 given to the tenth address bit of the address of the V-RAM 44, and the signal VRAM 10 is utilized for specifying the memory area accessible by the PPU 42 in the V-RAM 44 and controlling make or break of scrolling.

The read/write signal R/W from the CPU 34 is given to the terminal No. 17, one-bit serial data is given to the terminal No. 18 from the CPU 34, and one-bit data clear signal, that is, synchronizing timing signal of the above-described serial data is given to the terminal No. 19.

The signal ROMSEL1 which specifies addresses 8000H-FFFFH for the program memory 20 is given to the terminal No. 20 from the CPU 34.

Then, the program addresses A13 and A14 from the CPU 34 are given to the terminals No. 21 and No. 22. The system clock φ2 is given to the terminal No. 23.

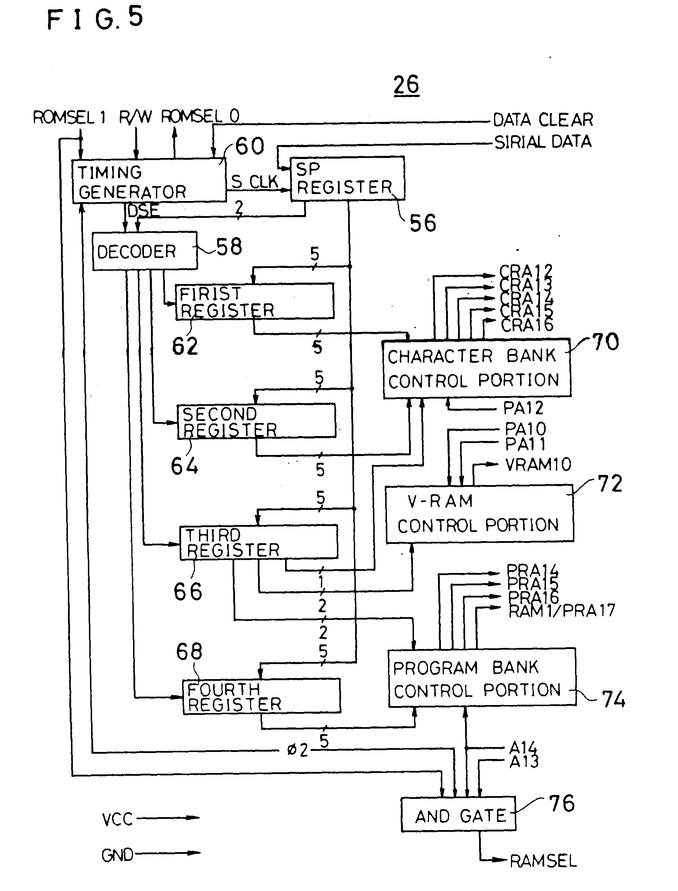

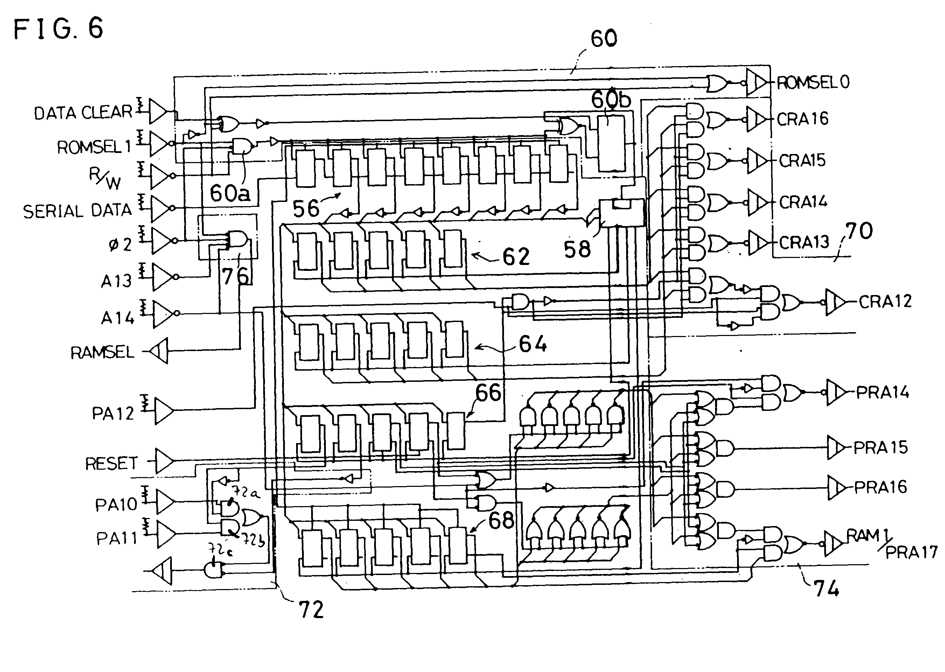

As shown in Fig. 5, an SP register 56 receiving serial data from the CPU 34 which is given to the above-described terminal No. 18 is installed in the MMC 26. As shown in Fig. 6, the SP register 56 is constituted as a seven-bit shift register, and the most significant two bits thereof are given to a decoder 58. Also, the MMC 26 includes a timing generator 60 which receives the signals ROMSELl and R/W, the data clear signal and the system clock φ2. Based on the signal ROMSEL1 and the signal R/W, the timing generator 60 outputs the low-level signal ROMSEL0 when the former is low and the latter is high, and gives a shift clock SCLK to the SP register 56 from an AND gate 60a (Fig. 6) in response to the system clock φ2. Along with it, the shift clock is counted by a counter 60b (Fig. 6) included in the timing generator 60, and the timing generator 60 gives a data set enable signal DSE to the decoder 58 at the timing of the seventh clock after the data clear signal has been given, that is, at the point when all the seven-bit serial data from the CPU 34 are loaded in the SP register 56.

The decoder 58 receives the most significant two bits of the data from the SP register 56, decodes them and gives a data set signal to any one of a first register 62, a second register 64, a third register 66 and a fourth register 68. Accordingly, the above-described SP register 56 and decoder 58 constitute a data multiplexer in cooperation with each other.

These first register 62 - fourth register 68 are all constituted as five-bit registers, and when given the data set signal by the decoder 58, the same load the remaining five-bit data of the SP register 56. The contents of these first register 62 - fourth register 68 are used as memory control data for the program memory 20, the character memory 22 or the V-RAM 44, for example, a bank specifying code.

A character bank control portion 70 receives respective five-bit data from the first register 62 and the second register 64, also receiving the least significant one bit from the third register 66. The address PA12 from the PPU 42 (Fig. 2) which is given through the edge connector 32 (Fig. 3) is further given to the character bank control portion 70. Then, the character bank control portion 70 includes a large number of gates as shown in Fig. 6, and outputs the character addresses CRA12 - CRA16 for bank change-over of the character memory 22 according to the gate processing of a large number of gates.

A V-RAM control portion 72 receives two-bit data from the third register 66, also receives the addresses PA10 and PA11 from the PPU 42, and outputs the address signal VRAM10 of the V-RAM 44 according to the gate processing of a large number of gates as shown in Fig. 6.

A program bank control portion 74 receives the most significant two bits of the third register 66 and five-bit data of the fourth register 68, also receives the program address A14 which is given from the CPU 34, and outputs the program addresses PRA14 - PRA17 for bank change-over of the program memory 20 according to the gate processing of a large number of gates as shown in Fig. 6.

Furthermore, a decoder 76 is, as necessary, installed in the MMC 26, and the program addresses A13 and A14 from the CPU 34 and also the system clock φ2 and the signal RAMSEL1 are given to the MMC 26. As shown in Fig. 6, the decoder 76 is composed of four-input AND gates, and outputs the signal RAMSEL for enabling the expansion memory 24 in response to a formation of predetermined conditions.

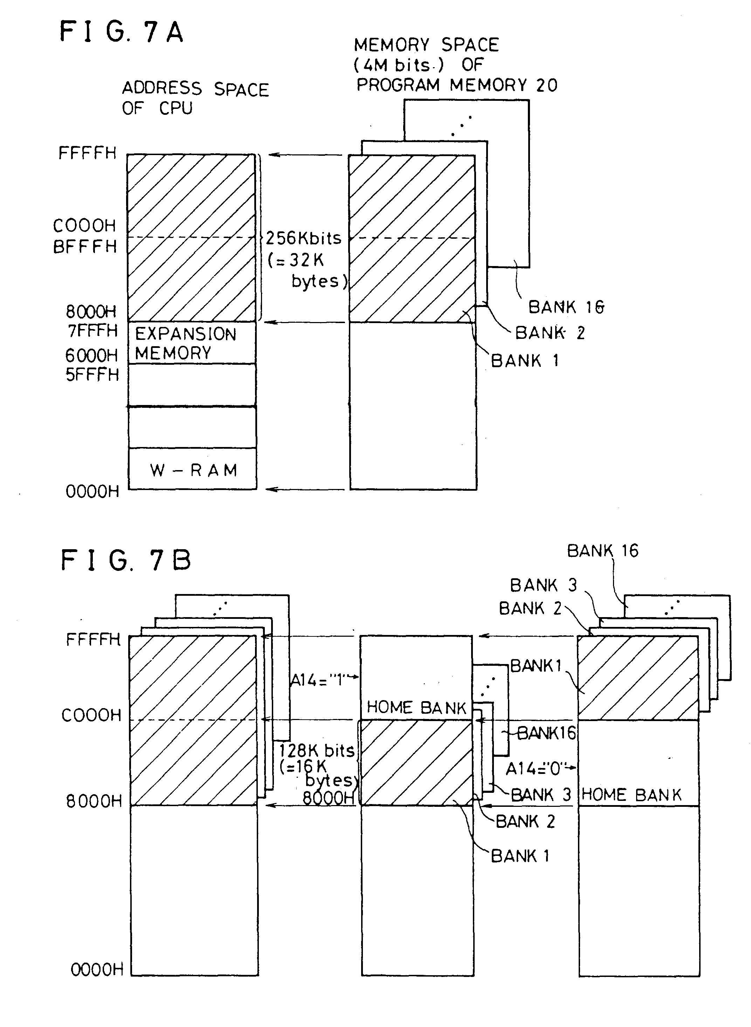

As described above, the CPU 34 is an eight-bit microcomputer, and accordingly the address space accessible by the CPU 34 is addresses 0000H - FFFFH represented by 2¹⁶ as shown in Fig. 7A. Among them, the addresses 0000H - 6000H are utilized as the W-RAM 36 as shown in Fig. 2 or another register area. Also, the addresses 6000H - 7FFFH among addresses 6000H - 8000H are utilized as address space for access to the expansion memory 24 (Fig. 3), and the addresses 8000H - FFFFH are utilized as address space, for access to one bank (256 K bits = 32 K bytes) of the program memory 20. Accordingly, in the case where the program memory 20 has a memory capacity of 4 M bits (512 K Byte), there are sixteen (16) banks of memory area which are addressed as address 8000H - FFFFH. These respective banks are changed-over by the MMC 26 as described later.

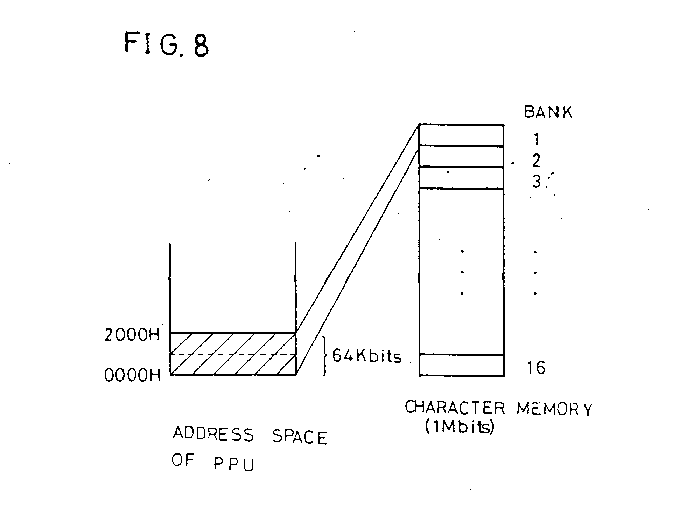

Also, in the PPU 42, as shown in Fig. 8, addresses 0000H - 2000H are utilized as addresses for access to one bank (64 K bits) of the character memory 22.

This means that in this embodiment, the program memory 20 of 4 M bits is divided into 16 banks of 256 K bits each, and these 16 banks are changed-over by the program bank control portion 74 (Fig. 5). Likewise, the character memory 22 of 1 M bits is divided into 16 banks of 64 K bits each, and these 16 banks are changed-over by the character bank control portion 70.

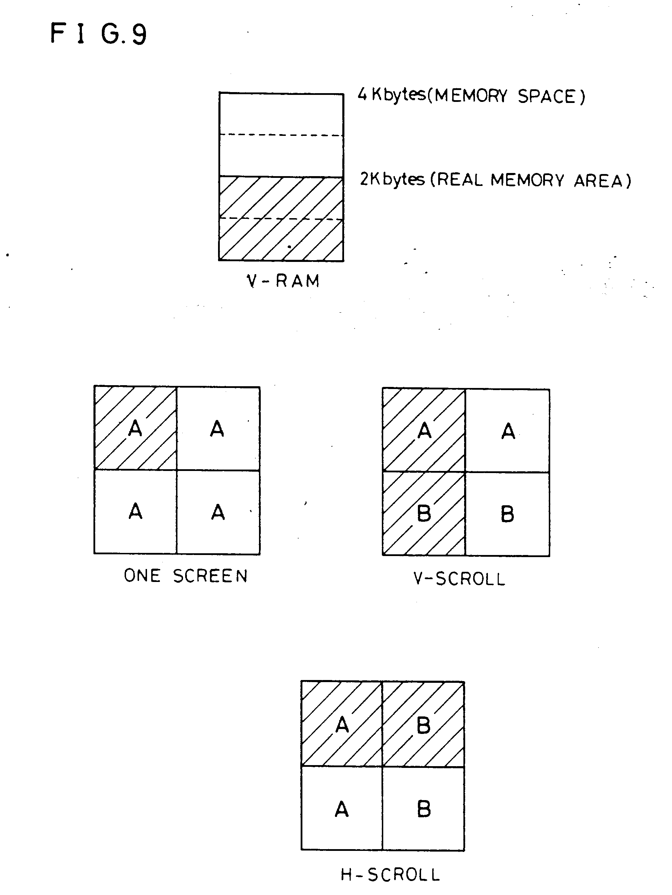

Also, the V-RAM 44 (Fig. 4) accessed by the PPU 42 has a memory area of 4 K bytes as shown in Fig. 9. However, practically, only 2 K bytes are employed as the V-RAM 44. Accordingly, when scrolling is made on a CRT as an image displaying means (not illustrated), it is required to change-over the addresses of the V-RAM 44 accessible by these 2 K bytes. This change-over of addresses is performed by the V-RAM control portion 72. This means that, as shown in Fig. 6, the V-RAM control portion 72 includes two AND gates 72a and 72b which receive the addresses PA10 and PA11 from the PPU 42 respectively, and which of the PA10 and the PA11 is to be given to the signal VRAM10 of the tenth address bit of the V-RAM 44 is selected by these AND gates 72a and 72b. By the selection, how the memory space of 2 K bytes of the V-RAM 44 be accessed, that is, how the memory area should be arranged in the address space is determined, resultingly the V scroll (when the PA10 is given to the VRAM10) or the H scroll (when the PA11 is given to the VRAM11) or a state where no scroll is performed is changed-over.

Then, when an AND gate 72c of the V-RAM control portion 72 is disabled by another bit output of the third register 66, the address PA10 or PA11 of the PPU 42 is not outputted as the signal VRAM10, and this signal VRAM10 of the tenth address bit of the V-RAM 44 goes low all the time, and in the case, a memory area of the V-RAM 44 for only one screen, that is, 1 K bytes is made accessible by the PPU 42 independent of the address from the PPU 42.

Next, description is made specifically on bank change-over of the program memory 20 and bank change-over of the character memory 22.

To change-over the banks of the program memory 20, serial data whose most significant two bits are "11" and whose remaining five bits are a code specifying any one of 16 banks of the program memory 20 is given to the terminal No. 18 of the MMC 26 from the CPU 34 through the edge connector 32. Then, the seven-bit data is loaded in the SP register 56, and at that point the signal DSE is outputted to the decoder 58 from the timing generator 60. The decoder 58 decodes two-bit data "11" of the SP register 56, giving the data set signal to the fourth register 68. Accordingly, the remaining five bits of the SP register 56 are loaded in the fourth register 68 at that point. The bank selection code loaded in the fourth register 68 is given to the program bank control portion 74.

The program bank control portion 74 outputs the addresses PRA14 - PRA17 for bank change-over of the program memory 20 when the most significant bit of five bits to be given is "0", and outputs the signal RAM1 working as a chip select signal to the expansion memory 24 from the terminal No. 4 when the most significant bit is "1". Accordingly, whether only the bank address of the program memory 20 is outputted from the program bank control portion 74 or a three-bit program address for bank change-over is outputted and a one-bit change-over signal for the expansion memory 24 is outputted depends on "0" or "1" of the most significant one bit among the five-bit data loaded in the fourth register 68.

Then, when the four-bit program addresses PRA14 - PRA17 are given to the program memory 20 from the program bank control portion 74, any one of 16 banks of the program memory 20 is enabled selectively by the four-bit address. Then, only the enabled bank is accessible directly by the CPU 34. This means that by utilizing the address space of 8000H -FFFFH, the CPU 34 accesses to that bank of the program memory 20.

Thus, for the banks of the program memory 20, an arbitrary bank is selected only by changing the serial data from the CPU 34, and therefore the bank change-over of the program memory 20 can be executed by program, that is, in a software fashion by entering such a bank select data in advance by the program of the CPU 34. The same is true of the bank change-over of the character memory 22 as described below.

Next, explanation is made on the case where the expansion memory 24 is selected. The expansion memory 24 is utilized when the memory capacity (2 K byte) of the W-RAM 36 in the main unit 30 is insufficient. Address 6000H - 7000H which is different from the address space (8000H -FFFFH) of the program memory 20 is assigned to the address space of the expansion memory 24. The AND gate 76 outputs the signal RAMSEL at a short timing when the AND condition is realized by the addresses A13 and A14, system clock φ2 and the inversion of the signal ROMSEL1. In response to the signal RAMSEL, the transistor 54 (Fig. 3) is turned on, therefore the expansion memory 24 is selected. In this state, the CPU 34 gives the address data within the address space and the data to be written to the expansion memory 24 so as to write the data into the expansion memory 24, or reads out the data from the expansion memory 24. When the system clock φ2 reverses, the AND gate 76 stops to output the signal RAMSEL, thereby the expansion memory 24 becomes a non-selected state. This means that the expansion memory 24 is selected within a short time of the machine cycle of the CPU 34 and having no relation to the change-over of the bank of the program memory 20, and the data is written or read into or from the expansion memory 24 in the real time. Thus, the address bus and the data bus of the program memory 20 can be used for the expansion memory (RAM) 24 without adding any address and data lines for CPU 34.

In addition, if a backup power source 16 is provided in association with the expansion memory 24 and the advanced game state such as a score, a stage number being advanced and the like is stored in the expansion memory 24, the data representing the game state of the game lastly executed is maintained and the next game can be started as a continuation of the last game even if the memory cartridge 10 is unloaded or the power switch is turned off after a termination of the game.

In addition, the program memory 20 may be changed-over as banks of 128 K bits (= 16 bytes) for example, each in place of the change-over on a 256 K bit bank basis. In such a case, the output of the third register 66 designates that the program memory 20 is to be bank changed-over for each unit of 128 K bits(=16 K bytes). When the address A14 is "1", the address space C000H - FFFFH is specified as a home bank, and the address space 8000H -BFFFH is bank changed-over based on the output of the fourth register 68 (see the middle of Fig. 7B). On the other hand, when the address A14 is "0", the address space 8000H - C000H is specified as the home bank , and the address space C000H - FFFFH is bank changed-over by the output of the fourth register 68 (see the right of Fig. 7B). Meanwhile, the home bank is an area where the program of the main routine and the like is stored. A system where the banks respectively having 256 K bits are changed-over is effectively used in the case where the programs are changed-over and executed on the bank basis. By contrast, a system where the banks respectively having 128 K bits are changed-over is effectively used in the case where the data for game (for example, the position of the character, data for specifying a kind of character) stored in such a bank is changed-over and utilized while the program of the home bank is executed. That is, the latter system is advantageous for executing an interrupt routine while the program of the home bank is executed, or for generating an effective sound.

Next, description is made on bank change-over of the character memory 22. The bank change-over of the character memory 22 can be selected from among two ways; the change-over on a 64 K bit bank basis or the bank change-over on a 32 K bit bank basis. This means that whether the character memory 22 is changed-over as 16 banks or as 32 banks is selected. Such a change-over of the bank size is performed by the least significant one bit of the third register 66, and the change-over is made on a 64 K bit bank basis when the least significant bit is "0", and on a 32 K bit bank basis when the bit is "1".

Then, when the least significant bit of the third register 66 is "1", the character bank control portion 70 selects by one of 32 banks of the character memory 22 based on the bank specifying code of a total of 10 bits from the first register 62 and the second register 64. Also, when the least significant bit of the third register 66 is "0" the character bank control portion 70 selectively enables any one of 16 banks according to the content of the most significant four bits of the second register 64.

Then, in the case where the character memory 22 is changed-over on a 32 K bit bank basis, the PPU 42 uses the address space 0000H - 0FFFH or 1000H - 1FFFH. In the case where the change-over on a 64 K bit bank basis is made, the PPU 42 uses the address space 0000H-1FFFFH.

In addition, in the above-described embodiment, the program memory 20 and the character memory 22 are constituted with separate memory chips, respectively. However, by constituting the both with the same ROM or RAM, the both may use respective different memory areas in the same memory chip.

Furthermore, in the above-described embodiment, one-chip memory having a large memory capacity is used as the program memory 20. However, a plurality of memory chips may be used if it is difficult to use such a large sized memory.

Although the present invention has been described and illustrated in detail, it is clearly understood that the same is by way of illustration and example only and is not to be taken by way of limitation, the scope of the present invention being limited only by the terms of the appended claims.

## Claims

1. A data processing apparatus comprising:
a first microprocessor (34) for producing conditional information and which is coupled to a first address bus;
a first memory (20) coupled to the first address bus, the memory being addressed by first address data output onto the first address bus by the first microprocessor (34) and having a memory area divided into a plurality of banks, the conditional information produced by the first microprocessor (34) including data representing bank changeover conditions;
a memory control means (26) having a plurality of registers (62,64,66,68) including a first register (64) for receiving and storing the conditional information and a first address generating means (74) for generating an address within one of the plurality of banks of the first memory (20) and derived from the conditional information stored in the register (64,68), the so-generated address falling within the first memory of the said one bank which is designated by the first microprocessor (34)
characterised in that the conditional information includes size data representing size conditions which define the size of the bank utilised by the microprocessor (34), in that the first address generating means (74) generates an address within one of the plurality of banks of the first memory (20) of appropriate size, in that the first memory (20) is attachable to and detachable from the first microprossor (34), in that the data processing apparatus further includes a second microprocessor (42) coupled to a second address bus, and a second memory (22) coupled to the second address bus and being attachable to and detachable from the second microprocessor, the second memory being addressed by second address data outputted onto the second address bus by the second microprossor (42), in that the conditional information produced by the first microprocessor (34) includes data representing bank changeover and bank size of the second memory (22), and in that the memory control means (26) includes a second address generating means (70) for generating an address within one of the plurality of banks of the second memory (22) of appropriate size and derived from the conditional information stored in a second register (68) and allways output from the first microprocessor (34), the so generated address specifying the appropriate bank designated by the first microprocessor (34).

2. A data processing apparatus according to claim 1, characterised in that the conditional information further includes at least one data bit (A14) defining which of the banks are changed according to the change-over conditions.

3. A data processing apparatus in accordance with claim 1 or 2, wherein said memory control means (26) includes a buffer register (56) in which said data representing bank change-over conditions can be temporarily loaded, and data loading means (58) for selectively loading data in any one of said plurality of registers (62,64,66,68) in response to the content of said buffer register (56).

4. A data processing apparatus in accordance with any one of the preceding claims, wherein said address generating means (70,72,74) includes a plurality of address generating circuits which respectively output an address for bank change-over for one of said plurality of memory areas in response to the content of at least one of said plurality of registers (62,66,67,68).

5. A data processing apparatus in accordance with claim 1, characterised in that the second microprocessor comprises a picture processing unit (42) for picture processing, in that the apparatus further includes a video memory (44) which is accessed by said picture processing unit (42), a video monitor for displaying an image on a screen thereof based on data from said picture processing unit (42), and in that said memory control means (26) includes area specifying means (72) for specifying a memory area of said video memory (44) accessible by said picture processing unit (42) based on data from said first microprocessor (34).

6. A data processing apparatus in accordance with claim 5, wherein an address space for said video memory (44) is equal to a first plurality of screens of said video monitor, and a real address of said video memory (44) is equal to a second plurality of screens less than said first plurality of screens,
said area specifying means (72) includes a signal outputting means for outputting a signal (VRAM10) representing that said memory area of said video memory (44) should be assigned in what place of said address space, whereby a vertical scrolling or horizontal scrolling occurs on the screen of said video monitor.

7. A data processing apparatus in accordance with claim 5, characterised in that said first memory (20) is a program memory (20) for storing a program of a picture processing and said second memory is character memory (22) for storing character data used for said image processing, and
said memory control means (26) includes program bank controlling means (74) for generating an address of bank change-over of said program memory (20) based on said data from said first microprocessor (34) and character bank controlling means (70) for generating an address for bank change-over of said character memory (22) based on said data from said first microprocessor (34).

8. A data processing apparatus according to one of the preceding claims,
characterised in that the first memory (20), the second memory and the memory control means (26) are installed on a printed circuit board (14) being connected with the data processing apparatus, wherein the printed circuit board (14) is part of a memory cartridge (10) which is attachable to and detachable from the data processing apparatus and is loaded in the data processing unit when it is used.

9. A data processing apparatus according to one of the claims 5 to 8, characterised in that the data processing apparatus is included in a game apparatus, wherein a game image is displayed on the screen of the video monitor on the basis of the program data stored in the program memory (20) and the character data stored in the character memory (22).

10. A data processing apparatus according to any preceding claim characterised in that the apparatus includes an expansion memory (24) separate from the primary memory (20,22) for holding data when the first or second memory is full, and in that the memory control means (26) addresses said expansion memory.

11. a data processing apparatus according to any of claims 3 to 10 wherein the data loading means (58) load data into the first address generating means (74) and the second generating means at timings different from each other.

12. A memory cartridge (10) for use in a data processing apparatus (30) which includes a first processor (34) coupled to a first address bus, said memory cartridge (10) comprising a first memory (20) coupled to said first address bus and whose memory area is divided into a plurality of banks, and a memory control means (26) which includes a register for receiving conditional information including data representing bank selection conditions of the first memory (20) output onto a data bus from said first processor (34), the first memory (20) being addressed by first address data output onto the first address bus by the first processor (34), the memory control means (26) further including a first output means (74) for outputting first bank selection data to the first memory (20) for performing bank selection and bank change-over, the memory control means (26) giving an upper portion of an address input for specifying a bank of the first memory (20)
characterised in that the memory control means includes a buffer register (56) for temporarily storing first bank selection data output onto the data bus by the first processor (34), in that the data processing apparatus (30) further includes a second processor (42) said memory cartridge (10) includes a second memory (22) coupled to a second address bus for being addressed by a second processor (42), coupled to the second address bus, in that the second memory (22) is divided into a plurality of banks, in that the buffer register (56) temporarily stores bank selection conditions of the second memory (22) output onto the data bus within the conditional information by the first processor (34), in that the memory control means (26) includes a first register (62) provided in correspondence to said first memory for holding said first bank selection data, a second register (68) provided in correspondence to said second memory (22) for holding said second bank selection data, loading means (58,60) for loading said first bank selection data and said second bank selection data into said first register (62,64) and said second register (66,68) respectively at times different from each other on the basis of load control data outputted by said first processor (34), second output means for outputting said second bank selection data held in the second register (68) to said second memory (22) for performing bank selection and bank change-over,and a further register (66) associated with at least one of the first register (62) and the second register (68) whereby a bank of at least one of the said first memory (20) and said second memory (22) can be selected in accordance with size conditions contained within the conditional information stored in the first and in the second registers and being always output from the first microprocessor, which define a size of a bank utilised by the first processor (34).

13. A memory cartridge according to claim 12, characterised in that one of said first memory and said second memory is a character memory for storing character data by which characters are displayed on a screen of a monitor and the other of them is a program memory for storing program data for controlling at least displayed conditions of said character.

## Patentansprüche

1. Datenverarbeitungsvorrichtung mit:
einem an einen ersten Adreßbus angeschlossen ersten Mikroprozessor (34) zum Erzeugen einer Bedingungsinformation;
einem an den ersten Adreßbus angeschlossen ersten Speicher (20), wobei der Speicher von von dem ersten Mikroprozessor (34) an den ersten Adreßbus abgegebenen ersten Adreßdaten adressiert wird und einen in eine Mehrzahl von Speicherbanken aufgeteilten Speicherbereich aufweist, wobei die von dem ersten Mikroprozessor (34) erzeugte Bedingungsinformation Daten enthält, die Speicherbankwechselbedingungen repräsentieren;
ein Speichersteuermittel (26) mit einer Mehrzahl von Registern (62, 64, 66, 68), die ein erstes Register (64) zum Empfangen und Speichern der Bedingungsinformation aufweisen, und einem ersten Adreßgeneratormittel (74) zum Erzeugen einer Adresse innerhalb einer Speicherbank von der Mehrzahl von Speicherbanken des ersten Speichers (20), wobei die Adresse von der in dem Register (64, 68) gespeicherten Bedingungsinformation abgeleitet ist, und die derart erzeugte Adresse innerhalb des ersten Speichers der von dem ersten Mikroprozessor (34) bestimmten Speicherbank liegt,
dadurch gekennzeichnet, daß die Bedingungsinformation Größendaten aufweist, die Größenbedingungen repräsentieren, die die Größe der von dem Mikroprozessor (34) verwendeten Speicherbank definieren, daß das erste Adreßgeneratormittel (74) eine Adresse innerhalb einer Speicherbank von der Mehrzahl von Speicherbanken des ersten Speichers (20) geeigneter Größe erzeugt, daß der erste Speicher (20) an den ersten Mikroprozessor (34) anschließbar und von diesem lösbar ist, daß die Datenverarbeitungsvorrichtung ferner einen an einen zweiten Adreßbus angeschlossenen zweiten Mikroprozessor (42) und einen an den zweiten Adreßbus angeschlossen zweiten Speicher (22) aufweist, der an den zweiten Mikroprozessor anschließbar und von diesem lösbar ist, wobei der zweite Speicher von von dem zweiten Mikroprozessor (42) an den zweiten Adreßbus abgegebenen zweiten Adreßdaten adressiert wird, daß die von dem ersten Mikroprozessor (34) erzeugte Bedingungsinformation Daten enthält, die den Speicherbankwechsel und die Speicherbankgröße des zweiten Speichers (22) repräsentieren, und daß die Speichersteuervorrichtung (26) ein zweites Adreßgeneratormittel (70) zum Erzeugen einer Adresse innerhalb einer Speicherbank von der Mehrzahl von Speicherbanken des zweiten Speichers (22) geeigneter Größe aufweist, wobei die Adresse von der in einem zweiten Register (68) gespeicherten Bedingungsinformation abgeleitet ist und immer von dem ersten Mikroprozessor (34) ausgegeben wird, und die derart erzeugte Adresse die entsprechende Speicherbank spezifiziert, die von dem ersten Mikroprozessor (34) bestimmt ist.

2. Datenverarbeitungsvorrichtung nach Anspruch 1, dadurch gekennzeichnet, daß die Bedingungsinformation ferner wenigstens ein Datenbit (A14) aufweist, das definiert, welche der Speicherbanken gemäß der Wechselbedingungen zu wechseln sind.

3. Datenverarbeitungsvorrichtung nach Anspruch 1 oder 2, wobei das Speichersteuermittel (26) ein Pufferregister (56), in das die die Datenbankwechselbedingungen repräsentierenden Daten vorübergehend einspeicherbar sind, und ein Dateneinlesemittel (58) zum selektiven Einlesen von Daten in irgendein Register von der Mehrzahl von Registern (62, 64, 66, 68) in Antwort auf den Inhalt des Pufferregisters (56) aufweist.

4. Datenverarbeitungsvorrichtung nach einem der vorangehenden Ansprüche, wobei das Adreßgeneratormittel (70, 72, 74) eine Mehrzahl von Adreßgeneratorschaltkreisen aufweist, die jeweils eine Adresse für den Speicherbankwechsel für einen Speicherbereich von der Mehrzahl von Speicherbereichen in Antwort auf den Inhalt wenigstens eines Registers von der Mehrzahl von Registern (62, 66, 67, 68) abgeben.

5. Datenverarbeitungsvorrichtung nach Anspruch 1, dadurch gekennzeichnet, daß der zweite Mikroprozessor eine Bildverarbeitungseinheit (42) zur Bildverarbeitung aufweist, daß die Vorrichtung ferner einen Videospeicher (44), auf den von der Bildverarbeitungseinheit (42) zugegriffen wird, und einen Videomonitor zum Anzeigen eines Bildes auf dessen Bildschirm aufgrund von Daten von der Bildverarbeitungseinheit (42) aufweist, und daß das Speichersteuermittel (26) Bereichsspezifizierungsmittel (72) zum Spezifizieren eines Speicherbereichs des Videospeichers (44) aufweist, und die Bildverarbeitungseinheit (42) auf den Speicherbereich aufgrund der Daten von dem ersten Mikroprozessor (34) zugreifen kann.

6. Datenverarbeitungsvorrichtung nach Anspruch 5, wobei ein Adreßraum für den Videospeicher (44) einer ersten Mehrzahl von Bildschirmbereichen des Videomonitors entspricht, und eine reale Adresse des Videospeichers (44) einer zweiten Mehrzahl von Bildschirmbereichen entspricht, die kleiner als die erste Mehrzahl von Bildschirmbereichen ist,
das Bereichsspezifizierungsmittel (72) ein Signalausgabemittel zum Ausgeben eines Signals (VRAM10) aufweist, das repräsentiert, welchem Ort des Adreßraums der Speicherbereich des Videospeichers (44) zugewiesen werden soll, wodurch ein vertikales Verschieben oder ein horizontales Verschieben auf dem Bildschirm des Videomonitors auftritt.

7. Datenverarbeitungsvorrichtung nach Anspruch 5, dadurch gekennzeichnet, daß der erste Speicher (20) ein Programmspeicher (20) zum Speichern eines Programms einer Bildverarbeitung ist, und der zweite Speicher ein Zeichenspeicher (22) zum Speichern von für die Bildverarbeitung verwendeten Zeichendaten ist, und
das Speichersteuermittel (26) ein Programmbanksteuermittel (74) zum Erzeugen einer Adresse für einen Speicherbankwechsel des Programmspeichers (20) aufgrund der Daten von dem ersten Mikroprozessor (34), und ein Zeichenbanksteuermittel (70) zum Erzeugen einer Adresse für den Speicherbankwechsel (22) des Zeichenspeichers aufgrund der Daten von dem ersten Mikroprozessor (34) aufweist.

8. Datenverarbeitungsvorrichtung nach einem der vorangehenden Ansprüche, dadurch gekennzeichnet, daß der erste Speicher (20), der zweite Speicher und das Speichersteuermittel (26) auf einer gedruckten Leiterplatte (14) montiert sind, die mit der Datenverarbeitungsvorrichtung verbunden ist, wobei die gedruckte Leiterplatte (14) ein Teil einer Speicherkassette (10) ist, die an die Datenverarbeitungsvorrichtung anschließbar und von dieser lösbar ist und bei dem Verwenden an die Datenverarbeitungseinheit angesteckt wird.

9. Datenverarbeitungsvorrichtung nach einem der Ansprüche 5 bis 8, dadurch gekennzeichnet, daß die Datenverarbeitungsvorrichtung von einem Spielgerät umfaßt wird, wobei ein Spielbild auf dem Bildschirm des Videomonitors aufgrund der in dem Programmspeicher (20) gespeicherten Programmdaten und der in dem Zeichenspeicher (22) gespeicherten Zeichendaten angezeigt wird.

10. Datenverarbeitungsvorrichtung nach einem der vorangehenden Ansprüche, dadurch gekennzeichnet, daß die Vorrichtung einen von dem Primärspeicher (20, 22) separaten Erweiterungsspeicher (24) zum Speichern von Daten aufweist, wenn der erste oder der zweite Speicher voll sind, und daß das Speichersteuermittel (26) den Erweiterungsspeicher adressiert.

11. Datenverarbeitungsvorrichtung nach einem der Ansprüche 3 bis 10, wobei das Dateneinlesemittel (58) Daten in das erste Adreßgeneratormittel (74) und in das zweite Generatormittel zu unterschiedlichen Zeiten einliest.

12. Speicherkassette (10) zum Verwenden in einer Datenverarbeitungsvorrichtung (30), die einen an einen ersten Adreßbus angeschlossenen ersten Prozessor (34) aufweist, wobei die Speicherkassette (10) einen an den ersten Adreßbus angeschlossenen ersten Speicher (20), dessen Speicherbereich in eine Mehrzahl von Speicherbanken aufgeteilt ist, und ein Speichersteuermittel (26) aufweist, das ein Register zum Empfangen von Bedingungsinformationen umfaßt, die Daten beinhalten, die Bankauswahlbedingungen für den ersten Speicher (20) repräsentieren und auf einen Datenbus von dem ersten Prozessors (34) ausgegeben werden, wobei der erste Speicher (20) von von dem ersten Prozessor (34) an den ersten Adreßbus abgegebenen ersten Adreßdaten adressiert wird, das Speichersteuermittel (26) ein erstes Ausgabemittel (74) zum Ausgeben von Auswahldaten für die erste Speicherbank an den ersten Speicher (20) zur Speicherbankauswahl und zum Speicherbankwechsel aufweist, wobei das Speichersteuermittel (26) einen höherwertigen Anteil eines Adreßeingangs zum Spezifizieren einer Speicherbank des ersten Speichers (20) erzeugt,
dadurch gekennzeichnet, daß das Speichersteuermittel ein Pufferregister (56) zum vorübergehenden Speichern der von dem ersten Prozessor (34) auf den Datenbus ausgegebenen Auswahldaten für die erste Speicherbank aufweist, daß die Datenverarbeitungsvorrichtung (30) ferner einen zweiten Prozessor (42) und die Speicherkassette (10) einen an einen zweiten Adreßbus angeschlossenen zweiten Speicher (22) aufweisen, der von einem an den zweiten Adreßbus angeschlossenen zweiten Prozessor (42) adressiert wird, daß der zweite Speicher (22) in eine Mehrzahl von Speicherbanken aufgeteilt ist, daß das Pufferregister (56) vorübergehend Bankauswahlbedingungen des zweiten Speichers (22) speichert, die in den Bedingungsinformationen enthaltend von dem ersten Prozessor (34) auf dem Datenbus ausgegeben werden, daß das Speichersteuermittel (26) ein erstes Register (62), das in Übereinstimmung mit dem ersten Speicher zum Speichern der Auswahldaten für die erste Speicherbank vorgesehen ist, ein zweites Register (68), das in Übereinstimmung mit dem zweiten Speicher (22) zum Speichern der Auswahldaten für die zweite Speicherbank vorgesehen ist, Einlesemittel (58, 60) zum Einlesen der Auswahldaten für die erste Speicherbank und der Auswahldaten für die zweite Speicherbank in das erste Register (62, 64) bzw. das zweite Register (66, 68) zu voneinander unterschiedlichen Zeiten auf der Basis von von dem ersten Prozessor (34) ausgegebenen Einlesesteuerdaten, ein zweites Ausgabemittel zum Ausgeben der in dem zweiten Register (68) gehaltenen Auswahldaten für die zweite Speicherbank an den zweiten Speicher (22) zur Speicherbankauswahl und zum Speicherbankwechsel, und ein zusätzliches Register (66) aufweist, das wenigstens einem Register von dem ersten Register (62) und dem zweiten Register (68) zugeordnet ist, wodurch eine Bank wenigstens eines Speichers von dem ersten Speicher (20) und dem zweiten Speicher (22) entsprechend den in den Informationsbedingungen enthaltenen Größenbedingungen ausgewählt werden kann, die die Größe einer von dem ersten Prozessor (34) verwendeten Speicherbank definieren, wobei die Informationsbedingungen in dem ersten und in dem zweiten Register gespeichert sind und immer von dem ersten Mikroprozessor ausgegeben werden.

13. Speicherkassette nach Anspruch 12, dadurch gekennzeichnet, daß ein Speicher von dem ersten Speicher und dem zweiten Speicher ein Zeichenspeicher zum Speichern von Zeichendaten ist, mittels derer Zeichen auf einen Bildschirm eines Monitors angezeigt werden, und der andere Speicher von dem ersten Speicher und dem zweiten Speicher ein Programmspeicher zum Speichern von Programmdaten ist, um wenigstens die Anzeigebedingungen der Zeichen zu steuern.

## Revendications

1. Appareil de traitement des données, comprenant :
un premier microprocesseur (34), pour produire des informations conditionnelles, et qui est couplé à un premier bus d'adresses ;
une première mémoire (20), couplée au premier bus d'adresses, la mémoire étant adressée par les premières données d'adresses envoyées en sortie sur le premier bus d'adresses par le premier microprocesseur (34) et ayant une zone de mémoire subdivisée en une pluralité de blocs, les informations conditionnelles produites par le premier microprocesseur (34) comprenant les données représentant les conditions de passage d'un bloc à l'autre ;
des moyens de commande de mémoire (26) ayant une pluralité de registres (62, 64, 66, 68), comprenant un premier registre (64) pour recevoir et stocker les informations conditionnelles et des premiers moyens générateurs d'adresses (74) pour générer une adresse dans l'un de la pluralité de blocs de la première mémoire (20) et dérivant des informations conditionnelles stockées dans le registre (64, 68), l'adresse ainsi générée tombant dans ladite première mémoire dudit un bloc qui est désigné par le premier microprocesseur (34),
caractérisé en ce que les informations conditionnelles comprennent les données de taille représentant les conditions de taille qui définissent la taille du bloc utilisé par le microprocesseur (34) ; que les premiers moyens générateurs d'adresses (74) génèrent une adresse dans l'un de la pluralité de blocs de la première mémoire (20) ayant une taille appropriée; que la première mémoire (20) peut être connectée au premier processeur (34) et peut en être déconnectée; que l'appareil de traitement des données comprend en outre un deuxième microprocesseur (42), couplé à un deuxième bus d'adresses, et une deuxième mémoire (22) couplée au deuxième bus d'adresses mais pouvant être connectée au deuxième microprocesseur et en être déconnectée, la deuxième mémoire étant adressée par les deuxièmes données d'adresses envoyées en sortie sur le deuxième bus d'adresses par le deuxième microprocesseur (42) ; que les informations conditionnelles produites par le premier microprocesseur (34) comprennent des données représentant le passage d'un bloc à l'autre et la taille des blocs de la deuxième mémoire (22) ; et en ce que les moyens de commande de mémoire (26) comprennent des deuxièmes moyens générateurs d'adresses (70) pour générer une adresse dans l'un de la pluralité de blocs de la deuxième mémoire (22) ayant la taille appropriée et dérivant des informations conditionnelles stockées dans un deuxième registre (68), et toujours sorties du premier microprocesseur (34), l'adresse ainsi générée spécifiant le bloc approprié désigné par le premier microprocesseur (34).

2. Appareil de traitement des données selon la revendication 1,
caractérisé en ce que les informations conditionnelles comprennent en outre au moins un bit de données (A14), qui définit les blocs qui passent de l'un à l'autre en fonction des conditions de passage.

3. Appareil de traitement des données selon la revendication 1 ou 2, dans lequel lesdits moyens de commande de mémoire (26) comprennent un registre tampon (56), dans lequel lesdites données représentant les conditions de passage d'un bloc à l'autre peuvent être temporairement chargées, et des moyens de chargement de données (58), pour assurer le chargement sélectif de données dans l'un quelconque de ladite pluralité de registres (62, 64, 66, 68) en réponse au contenu dudit registre tampon (56).

4. Appareil de traitement des données selon l'une quelconque des revendications précédentes, dans lequel lesdits moyens générateurs d'adresses (70, 72, 74) comprennent une pluralité de circuits générateurs d'adresses, qui respectivement envoient en sortie une adresse pour un passage d'un bloc à l'autre, pour l'une de ladite pluralité de zones de mémoire en réponse au contenu d'au moins l'un de ladite pluralité de registres (62, 66, 67, 68).

5. Appareil de traitement des données selon la revendication 1, caractérisé en ce que le deuxième microprocesseur comprend une unité de traitement d'images (42) pour le traitement d'images; que l'appareil comprend en outre une mémoire vidéo (44), à laquelle on accède par ladite unité de traitement d'images (42), un moniteur vidéo pour afficher une image sur un écran de ce dernier, se fondant sur les données provenant de ladite unité de traitement d'images (42) ; et en ce que lesdits moyens de commande de mémoire (26) comprennent des moyens de spécification de zone (72), destinés à spécifier une zone de mémoire de ladite mémoire vidéo (44), accessible par ladite unité de traitement d'images (42) sur la base des données provenant dudit premier microprocesseur (34).

6. Appareil de traitement des données selon la revendication 5, dans lequel un espace d'adresse destiné à ladite mémoire vidéo (44) est égal à une première pluralité d'écrans dudit moniteur vidéo, et une adresse réelle de ladite mémoire vidéo (44) est égale à une deuxième pluralité d'écrans, inférieure à ladite première pluralité d'écrans, lesdits moyens de spécification de zone (72) comprennent un moyen de sortie de signaux pour envoyer en sortie un signal (VRAM10) indiquant à quel emplacement dudit espace d'adresse doit être affectée ladite zone de mémoire de ladite mémoire vidéo (44), ce en conséquence de quoi un défilement vertical ou un défilement horizontal a lieu sur l'écran dudit moniteur vidéo.

7. Appareil de traitement des données selon la revendication 5, caractérisé en ce que la première mémoire (20) est une mémoire de programmes (20) pour stocker un programme de traitement d'image, et ladite deuxième mémoire est une mémoire de caractères (22), pour stocker des données de caractères utilisées pour ledit traitement d'image, et lesdits moyens de commande de mémoire (26) comprennent des moyens de commande de blocs de programme (74) pour générer une adresse de passage d'un bloc à l'autre dans ladite mémoire de programmes (20) sur la base desdites données provenant dudit premier microprocesseur (34), et des moyens (70) de commande de blocs de caractères pour générer une adresse destinée au passage d'un bloc à l'autre dans ladite mémoire de caractères (22) sur la base desdites données provenant dudit premier microprocesseur (34).

8. Appareil de traitement des données selon l'une des revendications précédentes, caractérisé en ce que la première mémoire (20), la deuxième mémoire et les moyens de commande de mémoire (26) sont installés sur une carte à circuits imprimés (14), qui est connectée à l'appareil de traitement des données, où la carte à circuits imprimés (14) fait partie d'une cartouche de mémoire (10), qui peut être connectée à l'appareil de traitement des données et peut en être déconnectée, et est chargée dans l'unité de traitement des données lors de son utilisation.

9. Appareil de traitement des données selon l'une des revendications 5 à 8, caractérisé en ce que l'appareil de traitement des données est incorporé dans un appareil de jeu, où une image de jeu est affichée sur l'écran du moniteur vidéo sur la base des données de programme stockées dans la mémoire de programmes (20) et des données de caractères stockées dans la mémoire de caractères (22).

10. Appareil de traitement des données selon l'une quelconque des revendications précédentes, caractérisé en ce que l'appareil comprend une mémoire d'expansion (24), distincte de la mémoire primaire (20, 22), destinée à contenir des données quand la première mémoire ou la deuxième mémoire est pleine, et en ce que les moyens de commande de mémoire (26) adressent ladite mémoire d'expansion.

11. Appareil de traitement des données selon l'une quelconque des revendications 3 à 10, dans lequel les moyens de chargement de données (58) chargent des données dans les premiers moyens générateurs d'adresses (74) et dans les deuxièmes moyens générateurs, selon des temps différents les uns des autres.

12. Cartouche de mémoire (10), pour utilisation dans un appareil de traitement des données (30), qui comprend un premier processeur (34) couplé à un premier bus d'adresses, ladite cartouche de mémoire (10) comprenant une première mémoire (20) couplée audit premier bus d'adresses, et dont la zone de mémoire est subdivisée en une pluralité de blocs, et un moyen de commande de mémoire (26), qui comprend un registre pour recevoir des informations conditionnelles, comprenant les données représentant les conditions de sélection des blocs de la première mémoire (20), envoyées en sortie sur un bus d'adresses à partir dudit premier processeur (34), la première mémoire (20) étant adressée par des premières données d'adresses envoyées en sortie sur le premier bus d'adresses par le premier processeur (34), les moyens de commande de mémoire (26) comprenant en outre des premiers moyens de sortie (74) pour envoyer en sortie des premières données de sélection de bloc à la première mémoire (20) pour procéder à une sélection des blocs et à un passage d'un bloc à l'autre, les moyens de commande de mémoire (26) donnant une portion supérieure d'une entrée d'adresses pour spécifier un bloc de la première mémoire (20),
caractérisée en ce que les moyens de commande de mémoire comprennent un registre tampon (56) pour stocker temporairement les premières données de sélection de bloc envoyées en sortie sur le bus de données par le premier processeur (34) ; que l'appareil de traitement des données (30) comprend en outre un deuxième processeur (42), ladite cartouche de mémoire (10) comprend une deuxième mémoire (22) couplée à un deuxième bus d'adresses pour adressage par un deuxième processeur (42) couplé au deuxième bus d'adresses ; que la deuxième mémoire (22) est subdivisée en une pluralité de blocs ; en ce que le registre tampon (56) stocke temporairement les conditions de sélection des blocs de la deuxième mémoire (22) envoyées en sortie sur le bus de données dans le cadre des informations conditionnelles par le premier processeur (34) ; que les moyens de commande de mémoire (26) comprennent un premier registre (62), qui est en correspondance avec ladite première mémoire pour contenir lesdites premières données de sélection de bloc, un deuxième registre (68) qui est en correspondance avec ladite deuxième mémoire (22) pour contenir lesdites deuxièmes données de sélection de bloc, des moyens de chargement (58, 60) pour charger lesdites premières données de sélection de bloc et lesdites deuxièmes données de sélection de bloc, respectivement dans ledit premier registre (62, 64) et dans ledit deuxième registre (66, 68), à des temps différents les uns des autres, sur la base des données de commande de chargement envoyées en sortie par ledit premier processeur (34), des deuxièmes moyens de sortie pour envoyer en sortie lesdites deuxièmes données de sélection de bloc contenues dans le deuxième registre (68) à ladite deuxième mémoire (22) pour réaliser une sélection de bloc et un passage d'un bloc à l'autre, et un registre supplémentaire (66), associé à au moins l'un du premier registre (62) et du deuxième registre (68), de sorte qu'un bloc d'au moins l'une de ladite première mémoire (20) et de ladite deuxième mémoire (22) peut être sélectionné en fonction de conditions de taille contenues à l'intérieur des informations conditionnelles stockées dans le premier et dans le deuxième registres et étant toujours envoyées à partir du premier microprocesseur, informations qui définissent une taille d'un bloc utilisé par le premier processeur (34).

13. Cartouche de mémoire selon la revendication 12, caractérisé en ce que l'une de ladite première mémoire et de ladite deuxième mémoire est une mémoire de caractères pour stocker des données de caractères, ce par quoi des caractères sont affichés sur un écran d'un moniteur, et l'autre desdites mémoire est une mémoire de programmes pour stocker des données de programmes destinées à commander au moins les conditions affichées dudit caractère.
